# FASCICULE DE BREVET EUROPEEN

(11) **EP 2 788 442 B1**
(45) Date de publication et mention de la délivrance du brevet: **27.04.2016**
(21) Numéro de dépôt: 12810352.0
(22) Date de dépôt: 05.12.2012
(51) Int. Cl.: C09D 133/10, C09D 125/08, C09D 133/04, C09D 153/00, C08F 293/00, B05D 7/00

(54) **PROCEDE DE PREPARATION DE SURFACES**
VERFAHREN ZUR VORBEREITUNG VON OBERFLÄCHEN
METHOD FOR PREPARING SURFACES

(30) Priorité: 09.12.2011 FR 1161423; 27.02.2012 US 201261603563 P
(43) Date de publication de la demande: 15.10.2014
(73) Titulaire: Arkema France, 92700 Colombes (FR); Commissariat à l'Énergie Atomique et aux Énergies Alternatives, 75015 Paris (FR)
(72) Inventeur: NAVARRO, Christophe, F-64100 BAYONNE (FR); MAGNET, Stéphanie, F-64370 Morlanne (FR); CHEVALIER, Xavier, F-38100 Grenoble (FR); TIRON, Raluca, F-38950 Saint-Martin-le-Vinoux (FR); COUDERC, Christophe, F-38400 Saint-Martin-d'Hères (FR)
(74) Mandataire: Lhoste, Catherine
(86) Numéro de dépôt international: PCT/FR2012/052813
(87) Numéro de publication internationale: WO 2013/083919

(56) Documents cités:
- HYUNJUNG JUNG ET AL: "Three-Dimensional Multilayered Nanostructures with Controlled Orientation of Microdomains from Cross-Linkable Block Copolymers", ACS NANO, vol. 5, no. 8, 23 août 2011 (2011-08-23), pages 6164-6173, XP055057470, ISSN: 1936-0851, DOI: 10.1021/nn2006943
- LIU GUOLIANG ET AL: "Modification of a polystyrene brush layer by insertion of poly(methyl methacrylate) molecules", JOURNAL OF VACUUM SCIENCE AND TECHNOLOGY: PART B, AVS / AIP, MELVILLE, NEW YORK, NY, US, vol. 27, no. 6, 4 décembre 2009 (2009-12-04), pages 3038-3042, XP012129622, ISSN: 1071-1023, DOI: 10.1116/1.3253607 cité dans la demande
- X. CHEVALIER ET AL: "Study and optimization of the parameters governing the block copolymer self-assembly: toward a future integration in lithographic process", PROCEEDINGS OF SPIE, vol. 7970, 1 janvier 2011 (2011-01-01), page 79700Q, XP055027423, ISSN: 0277-786X, DOI: 10.1117/12.881481
- RALUCA TIRON ET AL: "Optimization of block copolymer self-assembly through graphoepitaxy: A defectivity study", JOURNAL OF VACUUM SCIENCE & TECHNOLOGY B: MICROELECTRONICS AND NANOMETER STRUCTURES, vol. 29, no. 6, 1 janvier 2011 (2011-01-01), page 06F206, XP055027426, ISSN: 1071-1023, DOI: 10.1116/1.3659714
- P. MANSKY: "Controlling Polymer-Surface Interactions with Random Copolymer Brushes", SCIENCE, vol. 275, no. 5305, 7 mars 1997 (1997-03-07), pages 1458-1460, XP055017500, ISSN: 0036-8075, DOI: 10.1126/science.275.5305.1458 cité dans la demande

## Description

L'invention concerne un nouveau procédé de préparation de surface utilisant une combinaison d'au moins deux polymères, distincts ou non, greffés de façon hiérarchique ou multiple sur une surface.

L'invention concerne également l'utilisation de ce nouveau procédé de préparation, en particulier dans les applications de contrôle de l'énergie de surface d'un support. L'invention peut permettre de structurer un polymère à blocs avec un minimum de défauts.

En raison de leur capacité à se nanostructurer, l'utilisation des copolymères à blocs dans les domaines de l'électronique ou de l'optoélectronique est maintenant bien connue. Cela est en particulier illustré dans l'article de Cheng et al (ACS nano, Vol. 4, N° 8, 4815-4823, 2010). Il est en particulier possible de structurer l'arrangement des blocs constituant les copolymères à des échelles inférieures à 50 nm.

La structuration recherchée (par exemple, génération des domaines perpendiculaires à la surface) nécessite cependant la préparation du support sur lequel le copolymère à blocs est déposé en vue de contrôler l'énergie de surface. Parmi les possibilités connues, on dépose sur le support un polymère, plus particulièrement un polymère statistique dont les monomères peuvent être identiques en tout ou partie à ceux utilisés dans le copolymère à blocs que l'on veut déposer.

En outre, si l'on souhaite éviter par exemple la diffusion du polymère, il est préférable de greffer et/ou de réticuler le polymère sur la surface, par l'utilisation de fonctionnalités chimiques adéquates. On entend par greffage la formation d'une liaison par exemple covalente entre le support et le polymère. Par réticulation on entend la présence de plusieurs liaisons entre les chaînes de polymères.
Lorsque le même polymère est utilisé de façon séquentielle, on désigne le greffage comme multiple. Il s'agit en fait de répéter plusieurs fois le greffage (dépôt, recuit et rinçage solvant) du polymère. Lorsque des polymères de masse moléculaire et/ou de composition différentes sont appliqués, on désigne alors le greffage comme hiérarchique. Dans ce dernier cas, l'application des polymères peut se faire de façon simultanée ou successive.

### Art antérieur :

Parmi les différentes possibilités utilisées pour orienter la morphologie d'un copolymère à blocs sur une surface, on dépose préalablement sur la surface une couche d'un polymère statistique PMMA/PS.
Mansky et al. dans Science, vol 275 pages 1458-1460 (7 mars 1997) ont montré qu'un polymère statistique Poly (méthacrylate de méthyle co styrène) (PMMA/PS) fonctionnalisé par une fonction hydroxy en bout de chaîne permet un bon greffage du polymère à la surface. Les auteurs attribuent la faculté de greffage de ces polymères à la présence du groupement terminal hydroxy provenant de l'amorceur, ce qui constitue un mécanisme de greffage par condensation peu performant de part la température et les temps nécessaires, typiquement 24 à 48 h, à 140°C dans cette publication.

A une certaine fraction molaire des monomères méthacrylate de méthyle et styrène (MMA et STY), les énergies d'interface d'un polymère statistique avec le PS et respectivement le PMMA sont rigoureusement les mêmes (Mansky et al., Macromolecules 1997, 30, 6810-6813). Cette situation se présente dans le cas d'un support silicium présentant une fine couche d'oxyde à la surface. Dans ce cas, cela peut présenter un inconvénient car la composition idéale du polymère statistique doit exactement présenter cette fraction pour que les énergies des interfaces avec le PS et avec le PMMA soient les mêmes. Lorsque la composition du polymère statistique change, les auteurs ont montré qu'un copolymère diblocs PS-PMMA déposé sur le polymère statistique peut présenter des morphologies qui dépendent de la composition du polymère statistique. On peut donc changer la morphologie du copolymère diblocs en cas de dérive de la fraction MMA/STY du polymère statistique.

Plus récemment certains auteurs (Han et al., Macromolecules, 2008, 9090-9097, Ji et al Macromolecules, 2008, 9098-9103, Insik In et al., Langmuir 2006, 22, 7855-7860) ont montré qu'on pouvait avantageusement améliorer le greffage du polymère statistique sur la surface en introduisant, non plus en bout de chaîne, mais au sein même du polymère statistique plusieurs fonctionnalités telles que hydroxy ou époxy. Dans ce cas le polymère est greffé par plusieurs fonctions sur la surface (cas des hydroxy) et en plus réticulé à la surface (cas des epoxy).
Si les approches préalablement décrites dans la littérature autorisent certains contrôles de l'orientation d'un copolymère à blocs sur une surface traitée par un polymère statistique, il apparaît souvent de nombreux défauts de morphologie du copolymère à bloc déposé, préjudiciables aux applications industrielles notamment dans les domaines de l'électronique.

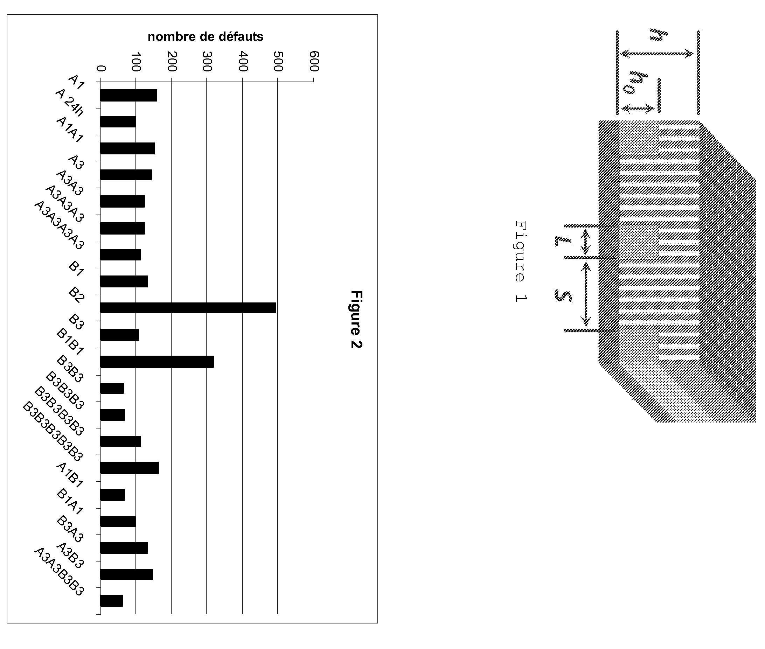

Hyunjung Jung et al. dans ACS NANO, vol 5, pages 6164-6173 (13 Juillet 2011) décrivent un procédé pour contrôler la structuration de copolymères à bloc polystyrène/polyméthacrylate de méthyle (PS-b-PMMA) comprenant l'étape de mise en contact de la surface du silicium avec une solution de polymère statistique polystyrène/ polyméthacrylate de méthyle (PS-r-PMMA), et une deuxième étape où la surface traitée par le polymère est mise en contact avec une solution d'un copolymère à bloc P(S-r-S-N3)-b-PMMA, dans lequel les monomères styrène et 4-vinylbenzène chloride sont copolymérisés de façon statistique par polymérisation radicalaire contrôlée (RAFT) (Figure 1 page 6165 et la partie expérimentale page 6171). Ensuite, la surface traitée par les deux polymères est mise en contact avec une solution d'un polymère à blocs polystyrène/polyméthacrylate de méthyle (PS-b-PMMA).

La demanderesse a maintenant découvert que les greffages hiérarchiques ou multiples d'au moins deux polymères de composition équivalente ou non et de masses moléculaire différente ou non sur une surface, autorise une orientation d'un copolymère à bloc ultérieurement déposé avec un minimum de défauts, comparé au greffage d'une seule couche de polymère. La demanderesse a constaté que l'épaisseur des couches n'évolue pas lors des greffages hiérarchiques ou multiples ce qui garantit une constance des paramètres lithographiques jusqu'à l'application du copolymère à blocs.
Un autre avantage de l'invention concerne l'ajustement de l'énergie de surface. Lorsqu'un seul polymère est utilisé, tel que décrit dans l'art antérieur, il correspond à une énergie de surface donnée après dépôt, permettant le dépôt ultérieur d'un copolymère à bloc de même énergie de surface. Or il n'est pas toujours facile d'avoir exactement la même énergie de surface entre le polymère servant à préparer la surface et le copolymère à bloc devant se structurer. Avec la présente invention, on peut modifier l'énergie de surface du premier polymère déposé sur la surface à l'aide d'un deuxième polymère de composition différente ce qui permet un réglage fin de l'énergie de surface et donc une meilleure égalisation des énergies de surface entre les polymères servant à préparer la surface et le copolymère à bloc devant se structurer.
Si Nealey et al (J. Vac. Sci. Technol. B 27(6), 2009) décrit l'application de deux polymères de façon successive (un polystyrène puis un PMMA), cette application vise à ajuster les énergies de surface, sans considérer une conséquence sur les défauts de structuration d'un copolymère à blocs déposé ultérieurement sur la surface traitée.
De même, T.Vu et Al dans Macromolecules, 2011, 44 (15), pp 6121-6127 considèrent la possibilité de faire une deuxième étape de greffage, sans considérer une conséquence sur les défauts de structuration d'un copolymère à blocs déposé ultérieurement sur la surface traitée.

### Résumé de l'invention :

La présente invention concerne un procédé de préparation de surface choisie parmi le silicium, le silicium présentant une couche d'oxyde natif ou thermique, le germanium, le platine, le tungstène, l'or, les nitrures de titane, les graphènes, le BARC (bottom anti reflecting coating) ou tout autre couche anti-reflective utilisée en lithographie, utilisant n polymères, distincts ou non, n étant un nombre entier supérieur ou égal à 2 comprenant les n étapes successives suivantes :
- mise en contact d'une solution ou dispersion du polymère i, i prenant les valeurs entières successives de 1 à n, avec la surface à traiter puis évaporation du solvant de solubilisation ou de dispersion ayant servi pour la mise en contact du polymère i avec la surface à traiter, suivi d'une étape permettant le greffage chimique du polymère tel que traitement thermique, photochimique.
- répétition de l'étape précédente avec le polymère j=i+1 sur la surface traitée par le polymère i de l'étape précédente.

### Description détaillée.

Le nombre optimum d'étapes de greffage n est dépendant de la masse moléculaire des polymères utilisés pour le greffage. Pour les masses moléculaires en poids inférieures à 10000 g/mole, n est un nombre entier supérieur à 1, de préférence compris entre 2 et 4, bornes comprises. Plus particulièrement n est égal à 3 et de façon encore préférée, n est égal à 2.
Pour les masses moléculaires en poids supérieures à 10000 g/mole, n est un nombre entier supérieur à 1, de préférence compris entre 3 et 7, bornes comprises. Plus particulièrement n est entre 3 et 6, bornes comprises et de façon encore préférée, n est compris entre 4 et 5, bornes comprises.

Selon un premier mode préféré de l'invention, le greffage se fait de façon multiple. Selon un deuxième mode préféré de l'invention, le greffage se fait de façon hiérarchique. Selon une alternative de l'invention, le greffage est effectué de façon simultanée avec des polymères dont la masse moléculaire en poids présente une différence supérieure ou égale à 20 % pris deux à deux.
La nanostructuration d'un copolymère à bloc d'une surface traité par le procédé de l'invention peut prendre les formes telles que cylindriques (symétrie hexagonale (symétrie de réseau *hexagonal primitif « 6mm* »)selon la notation de Hermann-mauguin, ou tétragonale/quadratique (symétrie de réseau *tétragonal primitif « 4mm* »)), ,sphérique (symétrie hexagonale (symétrie de réseau *hexagonal primitif « 6mm* » ou *« 6*/*mmm* »), ou tétragonale/quadratique (symétrie de réseau *tétragonal primitif « 4mm* »), ou cubique (symétrie de réseau « *m⅓m* »)), lamellaires, ou gyroïde. De préférence, la forme préférée que prends la nanostructuration est du type cylindrique hexagonal.

Le procédé d'auto-assemblage des copolymères à bloc sur une surface traitée selon l'invention est gouverné par des lois thermodynamiques. Lorsque l'auto-assemblage conduit à une morphologie de type cylindrique, chaque cylindre est entouré de 6 cylindres voisins équidistants s'il n'y a pas de défaut. Plusieurs types de défauts peuvent ainsi être identifiés. Le premier type est basé sur l'évaluation du nombre de voisin autour d'un cylindre que constitue l'arrangement du copolymère à bloc. Si cinq ou sept cylindres entourent le cylindre considéré, on considérera qu'il y a un défaut. Le deuxième type de défaut considère la distance moyenne entre les cylindres entourant le cylindre considéré. [W.Li, F.Qiu, Y.Yang, and A.C.Shi, Macromolecules 43, 2644 (2010) ; K. Aissou, T. Baron, M. Kogelschatz, and A. Pascale, Macromol. 40, 5054 (2007) ; R. A. Segalman, H. Yokoyama, and E. J. Kramer, Adv. Matter. 13, 1152 (2003); R. A. Segalman, H. Yokoyama, and E. J. Kramer, Adv. Matter. 13, 1152 (2003)]. Lorsque cette distance moyenne entre deux voisins est supérieure à deux % de la distance moyenne entre deux voisins, on considérera qu'il y a un défaut. Pour déterminer ces deux types de défauts, on utilise classiquement les constructions de Voronoï et les triangulations de Delaunay associées. Après binarisation de l'image, le centre de chaque cylindre est identifié. La triangulation de Delaunay permet ensuite d'identifier le nombre de voisins de premier ordre et de calculer la distance moyenne entre deux voisins. On peut ainsi déterminer le nombre de défauts.

Cette méthode de comptage est décrite dans l'article de Tiron et al. (J. Vac. Sci. Technol. B 29(6), 1071-1023, 2011.

Par polymère, on entend les homopolymères, les copolymères statistiques, à blocs ou à gradient, à peigne de masse moléculaire en poids mesurée par chromatographie d'exclusion stérique (SEC) supérieure à 500 g par mole et constitués d'au moins un monomère.
Les polymères utilisés dans le procédé de l'invention peuvent être obtenus par n'importe quelle voie parmi lesquelles on peut citer la polycondensation, la polymérisation par ouverture de cycle, la polymérisation anionique, cationique ou radicalaire cette dernière pouvant être contrôlée ou non. Lorsque les polymères sont préparés par polymérisation ou télomérisation radicalaire, celle-ci peut être contrôlée par toute technique connue telle que NMP ("Nitroxide Mediated Polymerization"), RAFT ("Reversible Addition and Fragmentation Transfer"), ATRP ("Atom Transfer Radical Polymerization"), INIFERTER ("Initiator-Transfer-Termination"), RITP (" Reverse Iodine Transfer Polymerization"), ITP ("Iodine Transfer Polymerization).

Les polymères utilisés dans l'invention sont des copolymères statistiques, c'est-à-dire qu'ils contiennent au moins deux monomères distincts.
On privilégiera les procédés de polymérisation ne faisant pas intervenir de métaux. Les polymères sont préparés par polymérisation radicalaire contrôlée, et particulièrement par polymérisation contrôlée par les nitroxydes.
Plus particulièrement les nitroxides issus des alcoxyamines dérivées du radical libre stable (1) sont préférées.

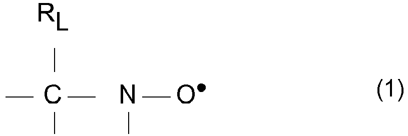

Dans laquelle le radical R_{L} présente une masse molaire supérieure à 15,0342 g/mole. Le radical R_{L} peut être un atome d'halogène tel que le chlore, le brome ou l'iode, un groupement hydrocarboné linéaire, ramifié ou cyclique, saturé ou insaturé tel qu'un radical alkyle ou phényle, ou un groupement ester -COOR ou un groupement alcoxyle -OR, ou un groupement phosphonate -PO(OR)₂, dès lors qu'il présente une masse molaire supérieure à 15,0342. Le radical R_{L}, monovalent, est dit en position β par rapport à l'atome d'azote du radical nitroxyde. Les valences restantes de l'atome de carbone et de l'atome d'azote dans la formule (1) peuvent être liées à des radicaux divers tels qu'un atome d'hydrogène, un radical hydrocarboné comme un radical alkyle, aryle ou aryle-alkyle, comprenant de 1 à 10 atomes de carbone. Il n'est pas exclu que l'atome de carbone et l'atome d'azote dans la formule (1) soient reliés entre eux par l'intermédiaire d'un radical bivalent, de façon à former un cycle. De préférence cependant, les valences restantes de l'atome de carbone et de l'atome d'azote de la formule (1) sont liées à des radicaux monovalents. De préférence, le radical R_{L} présente une masse molaire supérieure à 30 g/mole. Le radical R_{L} peut par exemple avoir une masse molaire comprise entre 40 et 450 g/mole. A titre d'exemple, le radical R_{L} peut être un radical comprenant un groupement phosphoryle, ledit radical R_{L} pouvant être représenté par la formule : 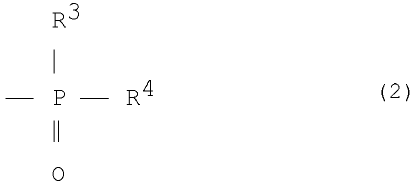 dans laquelle R³ et R⁴, pouvant être identiques ou différents, peuvent être choisis parmi les radicaux alkyle, cycloalkyle, alkoxyle, aryloxyle, aryle, aralkyloxyle, perfluoroalkyle, aralkyle, et peuvent comprendre de 1 à 20 atomes de carbone. R³ et/ou R⁴ peuvent également être un atome d'halogène comme un atome de chlore ou de brome ou de fluor ou d'iode. Le radical R_{L} peut également comprendre au moins un cycle aromatique comme pour le radical phényle ou le radical naphtyle, ce dernier pouvant être substitué, par exemple par un radical alkyle comprenant de 1 à 4 atomes de carbone.

Plus particulièrement les alcoxyamines dérivées des radicaux stables suivants sont préférées :
- N-tertiobutyl-1-phényl-2 méthyl propyl nitroxyde,
- N-tertiobutyl-1-(2-naphtyl)-2-méthyl propyl nitroxyde,
- N-tertiobutyl-1-diéthylphosphono-2,2-diméthyl propyl nitroxyde,
- N-tertiobutyl-1-dibenzylphosphono-2,2-diméthyl propyl nitroxyde,
- N-phényl-1-diéthyl phosphono-2,2-diméthyl propyl nitroxyde,
- N-phényl-1-diéthyl phosphono-1-méthyl éthyl nitroxyde,
- N-(1-phényl 2-méthyl propyl)-1-diéthylphosphono-1-méthyl éthyl nitroxyde,
- 4-oxo-2,2,6,6-tétraméthyl-1-piperidinyloxy,
- 2,4,6-tri-tert-butylphenoxy.

Outre leur énergie de liaison, les alkoxyamines utilisées en polymérisation radicalaire contrôlée doivent permettre un bon contrôle de l'enchaînement des monomères. Ainsi elles ne permettent pas toutes un bon contrôle de certains monomères. Par exemples les alcoxyamines dérivées du TEMPO ne permettent de contrôler qu'un nombre limité de monomères, il en va de même pour les alcoxyamines dérivées du 2,2,5-tri-methyl-4-phenyl-3-azahexane-3-nitroxyde (TIPNO). En revanche d'autres alcoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde permettent d'élargir à un grand nombre de monomère la polymérisation radicalaire contrôlée de ces monomères.
En outre la température d'ouverture des alcoxyamines influe également sur le facteur économique. L'utilisation de basses températures sera préférée pour minimiser les difficultés industrielles. On préférera donc les alkoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde à celles dérivées du TEMPO ou 2,2,5-tri-methyl-4-phenyl-3-azahexane-3-nitroxyde (TIPNO).

On entend par polymère à gradient un polymère d'au moins deux monomères obtenu généralement par polymérisation vivante ou pseudo vivante. Grâce à ces modes de polymérisation, les chaînes polymères croissent simultanément et donc incorporent à chaque instant les mêmes ratios de co-monomères. La distribution dans les chaînes polymères des co-monomères dépend donc de l'évolution, pendant la synthèse, des concentrations relatives des co-monomères. On se rapportera aux publications suivantes pour une description théorique des polymères à gradient : T. Pakula & al., Macromol. Theory Simul. 5, 987-1006 (1996) ; A. Aksimetiev & al. J. of Chem. Physics 111, n°5 ; M. Janco J. Polym. Sci., Part A: Polym. Chem. (2000), 38(15), 2767-2778 ; M. Zaremski, & al Macromolecules (2000), 33(12), 4365-4372 ; K. Matyjaszewski & al. J. Phys. Org. Chem. (2000), 13(12), 775-786 ; Gray Polym. Prepr. (Am. Chem. Soc., Div. Polym. Chem.) (2001), 42(2), 337-338 ; K. Matyjaszewski Chem. Rev. (Washington, D. C.) (2001), 101(9), 2921-2990.

Concernant les monomères qui peuvent être utilisés dans la composition des polymères, on peut citer:

Au moins un monomère vinylique, vinylidénique, diénique, oléfinique, allylique ou (méth)acrylique. Ce monomère est choisi plus particulièrement parmi les monomères vinylaromatiques tels que le styrène ou les styrènes substitués notamment l'alpha-méthylstyrène, les monomères acryliques tels que l'acide acrylique ou ses sels, les acrylates d'alkyle, de cycloalkyle ou d'aryle tels que l'acrylate de méthyle, d'éthyle, de butyle, d'éthylhexyle ou de phényle, les acrylates d'hydroxyalkyle tels que l'acrylate de 2-hydroxyéthyle, les acrylates d'étheralkyle tels que l'acrylate de 2-méthoxyéthyle, les acrylates d'alcoxy- ou aryloxy-polyalkylèneglycol tels que les acrylates de méthoxypolyéthylèneglycol, les acrylates d'éthoxypolyéthylèneglycol, les acrylates de méthoxypolypropylèneglycol, les acrylates de méthoxypolyéthylèneglycol-polypropylèneglycol ou leurs mélanges, les acrylates d'aminoalkyle tels que l'acrylate de 2-(diméthylamino)éthyle (ADAME), les acrylates fluorés, les acrylates silylés, les acrylates phosphorés tels que les acrylates de phosphate d'alkylèneglycol, les acrylates de glycidyle, de dicyclopentenyloxyethyle, les monomères méthacryliques comme l'acide méthacrylique ou ses sels, les méthacrylates d'alkyle, de cycloalkyle, d'alcényle ou d'aryle tels que le méthacrylate de méthyle (MAM), de lauryle, de cyclohexyle, d'allyle, de phényle ou de naphtyle, les méthacrylates d'hydroxyalkyle tels que le méthacrylate de 2-hydroxyéthyle ou le méthacrylate de 2-hydroxypropyle, les méthacrylates d'étheralkyle tels que le méthacrylate de 2-éthoxyéthyle, les méthacrylates d'alcoxy-ou aryloxy-polyalkylèneglycol tels que les méthacrylates de méthoxypolyéthylèneglycol, les méthacrylates d'éthoxypolyéthylèneglycol, les méthacrylates de méthoxypolypropylèneglycol, les méthacrylates de méthoxypolyéthylèneglycol-polypropylèneglycol ou leurs mélanges, les méthacrylates d'aminoalkyle tels que le méthacrylate de 2-(diméthylamino)éthyle (MADAME), les méthacrylates fluorés tels que le méthacrylate de 2,2,2-trifluoroéthyle, les méthacrylates silylés tels que le 3-méthacryloylpropyltriméthylsilane, les méthacrylates phosphorés tels que les méthacrylates de phosphate d'alkylèneglycol, le méthacrylate d'hydroxyéthylimidazolidone, le méthacrylate d'hydroxyéthylimidazolidinone, le méthacrylate de 2-(2-oxo-1-imidazolidinyl)éthyle, l'acrylonitrile, l'acrylamide ou les acrylamides substitués, la 4-acryloylmorpholine, le N-méthylolacrylamide, le méthacrylamide ou les méthacrylamides substitués, le N-méthylolméthacrylamide, le chlorure de méthacrylamido-propyltriméthyle ammonium (MAPTAC), les méthacrylates de glycidyle, de dicyclopentenyloxyethyle, l'acide itaconique, l'acide maléique ou ses sels, l'anhydride maléique, les maléates ou hémimaléates d'alkyle ou d'alcoxy- ou aryloxy-polyalkylèneglycol, la vinylpyridine, la vinylpyrrolidinone, les (alcoxy) poly(alkylène glycol) vinyl éther ou divinyl éther, tels que le méthoxy poly(éthylène glycol) vinyl éther, le poly(éthylène glycol) divinyl éther, les monomères oléfiniques, parmi lesquels on peut citer l'éthylène, le butène, l'hexène et le 1-octène, les monomères dièniques dont le butadiène, l'isoprène ainsi que les monomères oléfiniques fluorés, et les monomères vinylidénique, parmi lesquels on peut citer le fluorure de vinylidène, seuls ou en mélange d'au moins deux monomères précités.
De préférence les polymères sont constitués des monomères parmi lesquels on peut citer le styrène, le méthacrylate de méthyle, le méthacrylate de glycidyle (GMA), le méthacrylate de 2- hydroxy éthyle (HEMA), l'acrylate de méthyle ou d'éthyle. Le styrène est présent de préférence dans les polymères dans des quantités molaires allant de 40 à 100 % et encore plus préférentiellement de 60 à 85 %. Selon une première forme préférée de l'invention, les polymères statistiques présentent une masse moléculaire en poids Mw, mesurée par SEC avec des étalons polystyrène inférieure à 20000 g par mole, et plus particulièrement inférieure à 10000 g/mole. La dispersité du premier polymère, rapport des masses moléculaires moyennes en poids au masses moléculaires moyennes en nombre est inférieure à 5, plus particulièrement inférieure à 2, et de façon préférée inférieure à 1,5. Selon un premier aspect de l'invention, les polymères ont une masse moléculaire en poids inférieure à 10000g/mole. Selon un deuxième aspect de l'invention les polymères ont une masse moléculaire en poids supérieure à 10000 g/mole

Lorsque plus de deux polymères sont utilisés on les appellera polymère i, polymère i+1, et ils sont choisis de la façon suivante :
Pour les greffages hiérarchiques, les masses moléculaires en poids M_{w} sont choisies de telle sorte que la masse moléculaire en poids M_{w} du polymère i+1 est inférieure à la masse moléculaire en poids M_{w} du polymère i.

Pour les greffages multiples, les masses moléculaires en poids M_{w} des copolymères seront équivalentes.

Selon une forme préférée de l'invention, les polymères statistiques de l'invention sont préparés avec l'acide 2-méthyl-2-[N-tertiobutyl-N-(diéthoxyphosphoryl 2,2diméthylpropyl) aminoxy] propionique (Blocbuilder MA^{®} - Arkema), le styrène et le méthacrylate de méthyle.

Concernant le procédé de préparation de surface utilisant les polymères de l'invention, il est applicable sur le silicium, le silicium présentant une couche d'oxyde natif ou thermique, le silicium hydrogéné ou halogéné, le germanium, le germanium hydrogéné ou halogéné, le platine et oxyde de platine, le tungstène et oxydes, l'or, les nitrures de titane, les graphènes. De préférence la surface est minérale et plus préférentiellement du silicium. De manière encore plus préférentielle, la surface est du silicium présentant une couche d'oxyde natif ou thermique.

Selon une forme préférée de l'invention, les polymères à blocs déposés sur les surfaces traitées par le procédé de l'invention sont de préférence des polymères diblocs ou des polymères triblocs.

Le procédé de l'invention consiste à déposer de préférence les polymères préalablement dissouts ou dispersés dans un solvant adéquat selon des techniques connues de l'homme de métier comme par exemple la technique dite « spin coating », « docteur Blade » « knife system », « slot die system » mais tout autre technique peut être utilisée telle qu'un dépôt à sec, c'est-à-dire sans passer par une dissolution préalable.
Le procédé de l'invention visera à former une couche greffée de polymère(s) typiquement inférieure à 10nm et de préférence inférieure à 5 nm. Lorsque le procédé de l'invention est utilisé pour préparer des surfaces en vue d'un dépôt de polymère à blocs, les polymères seront de préférence des polymères statistiques et les énergies d'interaction avec les blocs du ou des copolymères à blocs ultérieurement déposé seront équivalentes à celle de la multitude de couches de polymères déposés ou du mélange de polymères déposés.

Selon un mode préféré de l'invention, les polymères sont greffés de façon séquentielle, c'est-à-dire les uns après les autres, mais on n'exclue pas de les greffer de façon combinée, c'est-à-dire que l'on greffe un mélange des polymères.
Le procédé de l'invention peut être utilisé pour contrôler la structuration de copolymères à bloc sur une surface, améliorer l'aptitude à l'impression d'encres ou de peinture, la mouillabilité, la résistance aux intempéries ou au vieillissement, l'adhésion, la biocompatibilité, la prévention de la migration des encres, la prévention des dépôts de protéines, de salissures ou des moisissures.
De préférence le procédé est utilisé pour contrôler la structuration d'un copolymère à blocs.

### Exemple 1 : préparation d'une alcoxyamine fonctionnalisée hydroxy à partir de l'alcoxyamine commerciale BlocBuilder^{®}MA :

Dans un ballon de IL purgé à l'azote, on introduit :
- 226,17 g de BlocBuilder^{®}MA (1 équivalent)
- 68,9 g d'acrylate de 2-hydroxyethyle (1 équivalent)
- 548 g d'isopropanol
Le mélange réactionnel est chauffé à reflux (80°C) pendant 4h puis l'isopropanol est évaporé sous vide. On obtient 297 g d'alcoxyamine fonctionnalisée hydroxy sous la forme d'une huile jaune très visqueuse.

### Exemple 2 :

Protocole expérimental de préparation de polymères Polystyrène / Polyméthacrylate de méthyle, à partir de l'alcoxyamine fonctionnalisée hydroxy préparée selon l'exemple 1.

Dans un réacteur en acier inoxydable équipé d'un agitateur mécanique et d'une double enveloppe, sont introduits le toluène, ainsi que les monomères tels que le styrène (S), le méthacrylate de méthyle (MMA), et l'alcoxyamine fonctionnalisée hydroxy. Les ratios massiques entre les différents monomères styrène (S) et méthacrylate de méthyle (MMA), sont décrits dans le tableau 1. La charge massique de toluène est fixée à 30% par rapport au milieu réactionnel. Le mélange réactionnel est agité et dégazé par un bullage d'azote à température ambiante pendant 30 minutes.
La température du milieu réactionnel est alors portée à 115°C. Le temps t=0 est déclenché à température ambiante. La température est maintenue à 115°C tout le long de la polymérisation jusqu'à atteindre une conversion des monomères de l'ordre de 70%. Des prélèvements sont réalisés à intervalles réguliers afin de déterminer la cinétique de polymérisation par gravimétrie (mesure d'extrait sec). Lorsque la conversion de 70% est atteinte, le milieu réactionnel est refroidi à 60°C et le solvant et monomères résiduels sont évaporés sous vide. Après évaporation, la méthyléthylcétone est additionnée au milieu réactionnel en quantité telle que l'on réalise une solution de polymère de l'ordre de 25% massique.
Cette solution de polymère est alors introduite goutte à goutte dans un bécher contenant un non-solvant (l'heptane), de manière à faire précipiter le polymère. Le ratio massique entre solvant et non-solvant (méthyléthylcétone/heptane) est de l'ordre de 1/10. Le polymère précipité est récupéré sous la forme d'une poudre blanche après filtration et séchage.

**Tableau 1**

| **Polymères** | **Etat initial de réaction** | | **Caractéristiques du polymère** | | | | |
|---|---|---|---|---|---|---|---|
| | **Composition massique initiale des monomères S/MMA** | **Ratio massique d'alcoxyamine par rapport aux monomères S et MMA** | **%PS^{(a)}** | **Mp^{(a)}** | **Mn^{(a)}** | **Mw^{(a)}** | **Ip^{(a)}** |
| **A** | 74/26 | 0,03 | 70% | 15210 | 12 060 | 15 760 | 1,3 |
| **B** | 74/26/0/0 | 0,07 | 73% | 8380 | 7 120 | 8 960 | 1,3 |

(a) Déterminées par chromatographie d'exclusion stérique. Les polymères sont solubilisés à 1g/l dans du THF stabilisé au BHT. L'étalonnage +est effectué grâce à des étalons de polystyrène monodisperses. La double détection par indice de réfraction et UV à 254nm permet de déterminer le pourcentage de polystyrène dans le polymère.

### Exemple 3 :

Outre les polymères décrits dans l'exemple 2 Le copolymère à bloc PS-b-PMMA (PS 46.1 kg.mol⁻¹, PMMA 21 kg.mol⁻¹, PDI = 1.09) a été acheté chez Polymer Source Inc. (Dorval, Québec) et utilisé sans purification ultérieure.

### Greffage sur SiO₂ :

Les plaques de silicium (orientation cristallographique {100}) sont découpées manuellement en pièces de 3x4 cm et nettoyées par traitement piranha (H₂SO₄/H₂O₂ 2:1 (*v:v*)) durant 15 minutes, puis rincées à l'eau dé-ionisée, et séchées sous flux d'azote juste avant fonctionnalisation. La suite de la procédure est celle décrite par Mansky &al. (Science, 1997, 1458), avec une seule modification (le recuit se fait sous atmosphère ambiante et non pas sous vide). Les polymères statistiques sont dissous dans du toluène afin d'obtenir des solutions à 1.5% en masse. Une solution de PS-r-PMMA est dispensée à la main sur un wafer fraîchement nettoyé, puis étalée par spin-coating à 700 rpm afin d'obtenir un film d'environ 90nm d'épaisseur. Le substrat est alors simplement déposé sur une plaque chauffante, préalablement portée à la température voulue, sous atmosphère ambiante durant un temps variable. Le substrat est alors lavé par sonication dans plusieurs bains de toluène durant quelques minutes afin d'éliminer le polymère non-greffé de la surface, puis séché sous flux d'azote.

### Caractérisations :

Les mesures d'épaisseur de film ont été effectuées sur un ellipsomètre Prometrix UV1280. Les images obtenues par microscopie électronique à balayage ont été effectuées sur un CD-SEM H9300 de chez Hitachi.

Concernant la mesure de nombre de défaut une méthodologie a été développée. Ainsi, des échantillons sont préalablement structurés avec des réseaux de lignes/espaces par lithographie « conventionnelle » (par exemple e-Beam, en utilisant une résine type HSQ). La hauteur des motifs de résine est h0, la largeur des lignes est L et celle des tranchées est S, comme décrit dans la figure 1. Sur ces échantillons le polymère statistique est ensuite greffé comme décrit précédemment, et le copolymère à bloc structuré par recuit. La hauteur du film de copolymère h est supérieure à h₀, hauteur de la tranchée. Il est à noter que h peut être inférieur à h₀, mais de façon préférée, dans le procédé de l'invention h est supérieur à h₀. La phase PMMA est ensuite retirée préférentiellement par rapport à la phase PS et les surfaces sont imagées en utilisant le CD-SEM. Les images ainsi obtenues sont ensuite traitées en utilisant l'algorithme décrit plus haut, basé sur les constructions de Voronoï, en prenant en compte à la fois le calcul du nombre de voisins et de distance moyenne entre les voisins. Le minimum de défaut correspond à une double condition de commensurabilité L = na0, et S = Na0, où n et N sont des entiers, et a0=√3/2L0, où L0 est la période intrinsèque du copolymère à bloc.

### Protocoles expérimentaux :

- Le procédé d'auto-assemblage, la hauteur des motifs lithographiés et l'épaisseur du copolymère à bloc sont constant à travers tous les échantillons réalisés, seul le greffage du/des copolymère(s) statistique(s) A et B diffère.
- Sur les histogrammes et les graphiques tracés, chaque point est une moyenne réalisée sur 10 photos prises aléatoirement sur la zone considérée. Chaque photo mesure une zone de l'échantillon de 1350 x 1350 nm.
- Pour les graphiques traitant des expériences d'ellipsométrie, chaque point est une moyenne réalisée à partir de 7 mesures différentes.

Afin de faciliter la lecture, la nomenclature suivante est utilisée:
- « A1 » = copolymère statistique « A », greffé durant le temps « t 1 »
- « A1A1 »= copolymère statistique « A » greffé deux fois successivement durant le temps « t 1 »
- « A1A1A1 »= copolymère statistique « A » greffé trois fois successivement durant le temps « t 1 »
- « A1B1 » = greffage du copolymère statistique « A » durant le temps « t 1 », suivi du greffage du copolymère statistique « B » durant le temps « t 1 »
Les temps suivants sont utilisés, sauf mention spéciale
- Temps « t 1 » = 15 minutes
- Temps « t 2 » = 30 minutes
- Temps « t 3 » = 5 minutes
La température utilisée pour le greffage est de 240°C.

Les mesures suivantes (tableau 2 et figure 2) du nombre de défauts ont été effectuées sur un rectangle de 1350x1350 nm :

| Tableau 2 | nombre de défauts | écart type |
|---|---|---|
| A1 | 159 | 37 |
| A 24h | 100 | 21 |
| A1A1 | 153 | 40 |
| A3 | 143 | 25 |
| A3A3 | 124 | 18 |
| A3A3A3 | 124 | 21 |
| A3A3A3A3 | 114 | 19 |
| B1 | 133 | 64 |
| B2 | 492 | 75 |
| B3 | 106 | 39 |
| B1B1 | 318 | 60 |
| B3B3 | 66 | 34 |
| B3B3B3 | 68 | 36 |
| B3B3B3B3 | 112 | 32 |
| B3B3B3B3B3 | 164 | 59 |
| A1B1 | 68 | 22 |
| B1A1 | 98 | 44 |
| B3A3 | 132 | 20 |
| A3B3 | 146 | 34 |
| A3A3B3B3 | 62 | 42 |

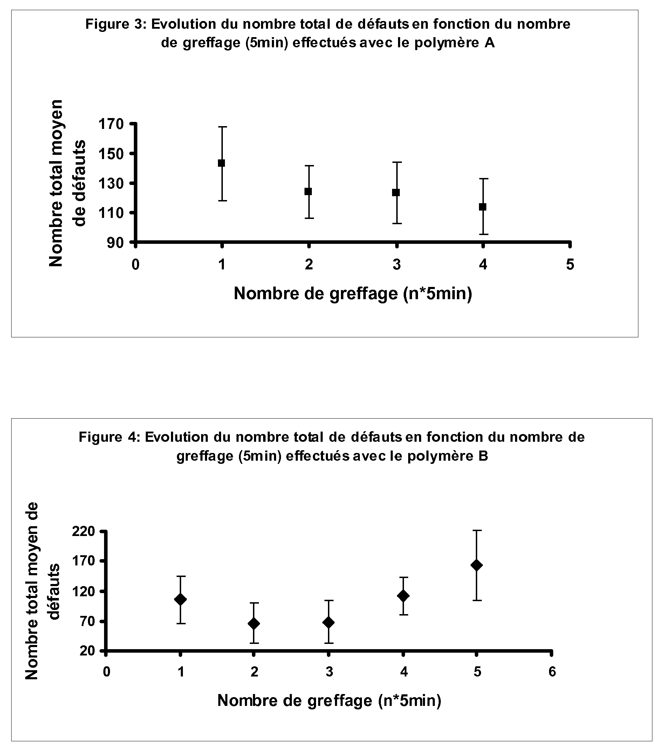

On constate que les meilleurs résultats se situent autour de 65 défauts et correspondent :
- Au greffage hiérarchique (A1B1)
- Au greffage multiple avec le polymère de plus basse masse moléculaire (B3B3, B3B3B3)
- Au greffage combiné multiple et hiérarchique (A3A3B3B3).
En outre, on observe un optimum du nombre de greffage qui se situe au delà de 4 pour le polymère A de plus forte masse (figure 3) et entre 2 et 3 (figures 4) pour le polymère B de plus basse masse.
On note bien que lors des greffages hiérarchiques, il est préférable que le premier polymère greffé ait une masse moléculaire plus importante que le deuxième polymère greffé (A1B1 comparé à B1A1).

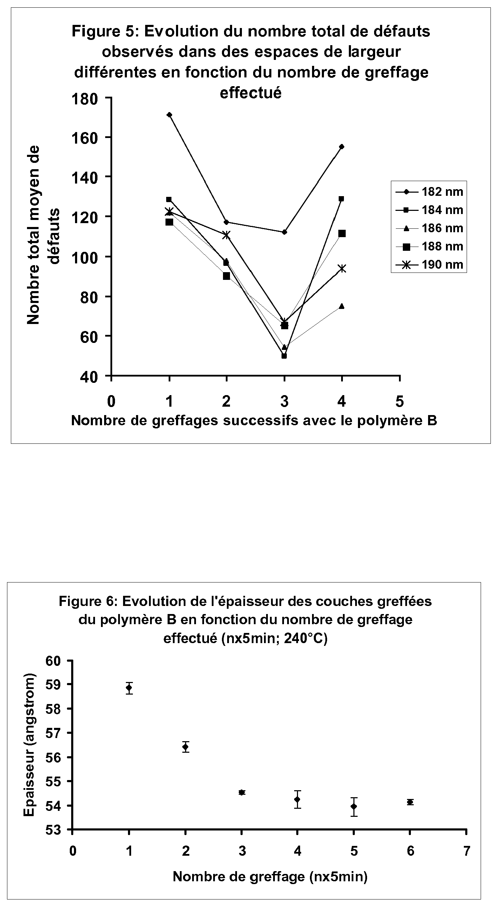

Par ailleurs lorsque que le paramètre S de la figure 1 varie de 182 à 190 nm l'optimum du nombre de couches greffées se situe toujours autour de 3 (figure 5) :

Enfin, la demanderesse à constaté que l'épaisseur des couches n'augmente pas lors des greffages hiérarchiques ou multiples ce qui garantit une constance des paramètres lithographiques jusqu'à l'application du copolymère à blocs, les paramètres h0, L et S de la figure 1 restent constant lors des greffages multiples et hiérarchiques. Ceci est vérifié en mesurant l'épaisseur de polymère résiduelle résultant des greffages successifs (figure 6) : cette épaisseur reste de l'ordre d'une couche monomoléculaire de polymère, même lorsque plusieurs étapes de greffage sont réalisées. On constate même que l'épaisseur à tendance à légèrement diminuer.

## Revendications

1. Procédé de préparation de surface choisie parmi le silicium, le silicium présentant une couche d'oxyde natif ou thermique, le germanium, le platine, le tungstène, l'or, les nitrures de titane, les graphènes, le BARC Bottom Anti Reflecting Coating ou tout autre couche anti-reflective utilisée en lithographie, utilisant n copolymères statistiques préparés par polymérisation radicalaire contrôlée, distincts ou non, n étant un nombre entier supérieur ou égal à 2 comprenant les n étapes successives suivantes:
- mise en contact d'une solution ou dispersion du polymère i, i prenant les valeurs entières successives de 1 à n, avec la surface à traiter puis évaporation du solvant de solubilisation ou de dispersion ayant servi pour la mise en contact du polymère i avec la surface à traiter, suivi d'une étape permettant le greffage chimique sur la surface tel que traitement thermique, photochimique;
- répétition de l'étape précédente avec le polymère j=i+1 sur la surface traitée par le polymère i de l'étape précédente.
Et suivit du dépôt d'un copolymère à bloc sur la surface ainsi traitée.

2. Procédé selon la revendication 1 dans lequel la masse moléculaire en poids des polymères est inférieure à 10000 g/mole.

3. Procédé selon la revendication 1 dans lequel la masse moléculaire en poids des polymères est supérieure à 10000 g/mole.

4. Procédé selon la revendication 2 dans lequel n est compris entre 2 et 4 bornes incluses

5. Procédé selon la revendication 3 dans lequel n compris entre 3 et 7 bornes comprises

6. Procédé selon la revendication 4 dans lequel n est égal à 3.

7. Procédé selon la revendication 1 dans lequel le greffage est effectué de façon hiérarchique.

8. Procédé selon la revendication 1 dans lequel la masse moléculaire en poids du polymère i+1 est inférieure à celle du polymère i.

9. Procédé selon la revendication 1 dans lequel le greffage est effectué de façon multiple.

10. Procédé selon la revendication 1 dans lequel le greffage est effectué de façon simultanée avec des polymères dont la masse moléculaire en poids présente une différence supérieure ou égale à 20 % pris deux à deux.

11. Procédé selon la revendication 1 dans lequel les polymères sont préparés par polymérisation radicalaire contrôlée par les nitroxydes.

12. Procédé selon la revendication 11 dans lequel les nitroxydes répondent à la formule suivante : 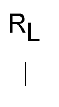 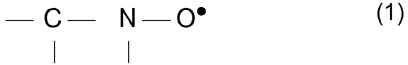 dans laquelle le radical R_{L} présente une masse molaire supérieure à 15,0342.

13. Procédé selon la revendication 12 dans lequel les nitroxydes suivants sont préférés :
- N-tertiobutyl-1-phényl-2 méthyl propyl nitroxyde,
- N-tertiobutyl-1-(2-naphtyl)-2-méthyl propyl nitroxyde,
- N-tertiobutyl-1-diéthylphosphono-2,2-diméthyl propyl nitroxyde,
- N-tertiobutyl-1-dibenzylphosphono-2,2-diméthyl propyl nitroxyde,
- N-phényl-1-diéthyl phosphono-2,2-diméthyl propyl nitroxyde,
- N-phényl-1-diéthyl phosphono-1-méthyl éthyl nitroxyde,
- N-(1-phényl 2-méthyl propyl)-1-diéthylphosphono-1-méthyl éthyl nitroxyde,
- 4-oxo-2,2,6,6-tétraméthyl-1-piperidinyloxy,
- 2,4,6-tri-tert-butylphenoxy.

14. Procédé selon la revendication 11 dans lequel le nitroxyde est le N-tertiobutyl-1-diéthylphosphono-2,2-diméthyl propyl nitroxyde.

15. Procédé selon la revendication 1 dans lequel les monomères constituants les copolymères statistiques sont le styrène et le méthacrylate de méthyle.

16. Procédé selon la revendication 1 dans lequel la surface est le silicium présentant une couche d'oxyde natif.

17. Procédé selon la revendication 1 dans lequel La hauteur du film de copolymère h est supérieure à h₀, hauteur de la tranchée.

18. Procédé selon la revendication 1 dans lequel la nano structuration du copolymère à bloc observée sur la surface traitée est du type cylindrique hexagonal.

19. Utilisation du procédé selon une quelconque des revendications 1 à 19 pour contrôler la structuration de copolymères à bloc, améliorer l'aptitude à l'impression d'encres ou de peinture, la mouillabilité, la résistance aux intempéries ou au vieillissement, l'adhésion, la biocompatibilité, la prévention de la migration des encres, la prévention des dépôts de protéines, de salissures ou des moisissures.

## Patentansprüche

1. Verfahren zur Vorbereitung einer Oberfläche, die ausgewählt ist aus Silicium, wobei das Silicium eine native oder thermische Oxidschicht aufweist, Germanium, Platin, Wolfram, Gold, Titannitriden, Graphenen, der Bodenantireflexbeschichtung (BARC = bottom antireflective coating) oder jeder anderen antireflektierenden Schicht, die in der Lithographie verwendet wird, wobei n statistische Copolymere verwendet werden, die durch kontrollierte radikalische Polymerisation hergestellt werden, die verschieden oder gleich sind, wobei n eine ganze Zahl ist, die größer oder gleich 2 ist, das die folgenden aufeinanderfolgenden Schritten aufweist:
- Inkontaktbringen einer Lösung oder Dispersion des Polymers i, wobei i die aufeinanderfolgenden ganzzahligen Werte von 1 bis n annimmt, mit der zu behandelnden Oberfläche und dann Verdampfen des Lösungsmittels der Solubilisierung oder der Dispersion, das für das Inkontaktbringen des Polymers i mit der zu behandelnden Oberfläche gedient hat, gefolgt von einem Schritt, der das chemische Aufpfropfen auf der Oberfläche gestattet, wie beispielsweise eine thermische, photochemische Behandlung;
- Wiederholen des vorhergehenden Schrittes mit dem Polymer j=i+1 auf der Oberfläche, die mit dem Polymer i des vorhergehenden Schrittes behandelt wird.
Und gefolgt von dem Aufbringen eines Blockcopolymers auf die auf diese Weise behandelte Oberfläche.

2. Verfahren nach Anspruch 1, wobei das Molekulargewicht der Polymere weniger als 10.000 g/mol beträgt.

3. Verfahren nach Anspruch 1, wobei das Molekulargewicht der Polymere mehr als 10.000 g/mol beträgt.

4. Verfahren nach Anspruch 2, wobei n von 1 bis 4, Grenzwerte eingeschlossen, beträgt.

5. Verfahren nach Anspruch 3, wobei n von 3 bis 7, Grenzwerte eingeschlossen, beträgt.

6. Verfahren nach Anspruch 4, wobei n gleich 3 ist.

7. Verfahren nach Anspruch 1, wobei das Aufpfropfen hierarchisch durchgeführt wird.

8. Verfahren nach Anspruch 1, wobei das Molekulargewicht des Polymers i+1 niedriger als jenes des Polymers i ist.

9. Verfahren nach dem Anspruch 1, wobei das Aufpfropfen mehrfach durchgeführt wird.

10. Verfahren nach Anspruch 1, wobei das Aufpfropfen gleichzeitig mit Polymeren durchgeführt wird, deren Molekulargewicht eine Differenz von mehr als oder gleich 20%, jeweils paarweise genommen, aufweist.

11. Verfahren nach Anspruch 1, wobei die Polymere durch radikalische Polymerisation hergestellt werden, die durch die Nitroxide gesteuert wird.

12. Verfahren nach Anspruch 11, wobei die Nitroxide der folgenden Formel entsprechen: 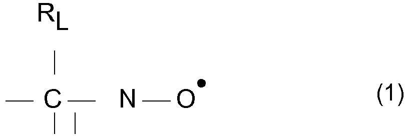 wobei das Radikal R_{L} eine Molmasse von mehr als 15,0342 aufweist.

13. Verfahren nach Anspruch 12, wobei die folgenden Nitroxide bevorzugt werden:
- N-tert.-Butyl-1-phenyl-2-methyl propyl Nitroxid,
- N-tert.-Butyl-1-(2-naphtyl)-2-methyl propyl Nitroxid
- N-tert.-Butyl-1-diethylphosphono-2,2-dimethyl propyl Nitroxid,
- N-tert.-Butyl-1-dibenzylphosphono-2,2-dimethyl propyl Nitroxid,
- N-Phenyl-1-diethylphosphono-2,2-dimethylpropyl Nitroxid,
- N-Phenyl-1-diethylphosphono-1-methylethyl Nitroxid,
- N-(1-Phenyl-2-methyl propyl)-1-diethylphosphono-1-methyl ethyl Nitroxid,
- 4-Oxo-2,2,6,6-tetramethyl-1-piperidinyloxy,
- 2,4,6-Tri-tert.-butylphenoxy.

14. Verfahren nach dem Anspruch 11, wobei das Nitroxid das N-tert.-Butyl-1-diethylphosphono-2,2-dimethyl propyl Nitroxid ist.

15. Verfahren nach Anspruch 1, wobei die Monomere, die die statistischen Copolymere bilden, Styrol und Methylmethacrylat sind.

16. Verfahren nach Anspruch 1, wobei die Oberfläche Silicium ist, das eine Schicht natives Oxid aufweist.

17. Verfahren nach Anspruch 1, wobei die Höhe der Copolymerfolie h größer als h₀, die Höhe des Einschnitts, ist.

18. Verfahren nach Anspruch 1, wobei die Nanostrukturierung des Blockcopolymers, die auf der behandelten Oberfläche beobachtet wird, vom hexagonalen, zylindrischen Typ ist.

19. Verwendung des Verfahrens nach einem der Ansprüche 1 bis 19, um die Strukturierung von Blockcopolymeren zu steuern, die Bedruckbarkeit von Tinten oder von Farbe, die Benetzbarkeit, die Beständigkeit gegen Witterung und Alterung, die Adhäsion, die Biokompatibilität, die Verhinderung der Migration der Tinten, die Verhinderung der Ablagerungen von Proteinen, Verschmutzungen oder von Schimmel zu verbessern.

## Claims

1. Method for preparing a surface selected from silicon, silicon having a thermal or native oxide layer, germanium, platinum, tungsten, gold, titanium nitrides, graphenes, BARC **B**ottom **A**nti-**R**eflecting **C**oating or any other anti-reflective layer used in lithography, utilizing n random copolymers prepared by controlled radical polymerization, which are different or not, n being an integer greater than or equal to 2, said method comprising the following n successive steps:
- contacting a solution or dispersion of the polymer i, i adopting the successive integral values from 1 to n, with the surface to be treated, then evaporating the dissolution or dispersion solvent used for contacting the polymer i with the surface to be treated, followed by a step of chemical grafting to the surface such as heat treatment, photochemical treatment;
- repeating the preceding step with the polymer j = i + 1 on the surface treated by the polymer i in the preceding step. And followed by depositing a block copolymer on the surface which has been treated in this way.

2. Method according to Claim 1, wherein the weight-average molecular mass of the polymers is less than 10 000 g/mol.

3. Method according to Claim 1, wherein the weight-average molecular mass of the polymers is greater than 10 000 g/mol.

4. Method according to Claim 2, wherein n is between 2 and 4 inclusive.

5. Method according to Claim 3, in which n is between 3 and 7 inclusive.

6. Method according to Claim 4, wherein n is 3.

7. Method according to Claim 1, wherein the grafting is carried out hierarchically.

8. Method according to Claim 1, wherein the weight-average molecular mass of the polymer i + 1 is less than that of the polymer i.

9. Method according to Claim 1, wherein the grafting is carried out multiply.

10. Method according to Claim 1, wherein the grafting is carried out simultaneously with polymers whose weight-average molecular mass exhibits a difference of greater than or equal to 20%, taken two by two.

11. Method according to Claim 1, wherein the polymers are prepared by nitroxide-controlled radical polymerization.

12. Method according to Claim 11, wherein the nitroxides conform to the formula below: 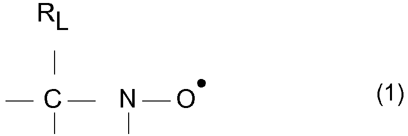 in which the radical R_{L} has a molar mass of more than 15.0342.

13. Method according to Claim 12, wherein the following nitroxides are preferred:
- N-tert-butyl 1-phenyl-2-methylpropyl nitroxide,
- N-tert-butyl 1-(2-naphthyl)-2-methylpropyl nitroxide,
- N-tert-butyl 1-diethylphosphono-2,2-dimethylpropyl nitroxide,
- N-tert-butyl 1-dibenzylphosphono-2,2-dimethylpropyl nitroxide,
- N-phenyl 1-diethylphosphono-2,2-dimethylpropyl nitroxide,
- N-phenyl 1-diethylphosphono-1-methylethyl nitroxide,
- N-(1-phenyl-2-methylpropyl) 1-diethylphosphono-1-methylethyl nitroxide,
- 4-oxo-2,2,6,6-tetramethyl-1-piperidinyloxy,
- 2,4,6-tri-tert-butylphenoxy.

14. Method according to Claim 11, wherein the nitroxide is N-tert-butyl 1-diethylphosphono-2,2-dimethylpropyl nitroxide.

15. Method according to Claim 1, wherein the monomers constituting the random copolymers are styrene and methyl methacrylate.

16. Method according to Claim 1, wherein the surface is silicon having a native oxide layer.

17. Method according to Claim 1, wherein the height of the copolymer film, h, is greater than h₀, the height of the trench.

18. Method according to Claim 1, wherein the nanostructuring of the block copolymer, observed on the treated surface, is of the hexagonal cylindrical type.

19. Use of the method according to any of Claims 1 to 19 for controlling the structuring of block copolymers, enhancing the printability of inks or paint, the wettability, the weathering or ageing resistance, the adhesion, the biocompatibility, the prevention of migration of inks, the prevention of deposits of proteins, of soiling or of moulds.
